# EUROPÄISCHE PATENTANMELDUNG

(11) **EP 2 073 028 A1**
(43) Veröffentlichungstag der Anmeldung: **24.06.2009**
(21) Anmeldenummer: 08105646.7
(22) Anmeldetag: 24.10.2008
(51) Int. Cl.: G01R 31/00, G01R 31/36

(54) **Sensoranordnung für die Zustandserkennung einer Batterie**

(30) Priorität: 19.12.2007 DE 102007061113
(71) Anmelder: ROBERT BOSCH GMBH, 70442 Stuttgart (DE)
(72) Erfinder: Ben Salah, Amin, 74321, Bietigheim-Bissingen (DE)

(57) **Zusammenfassung**

Die Erfindung betrifft eine Sensoranordnung für die Zustandserkennung einer Batterie (1) in einem Kraftfahrzeug, die zur Erfassung der elektrischen Zustandsgrößen der Batterie (1) in der Nähe der Polklemmen (2,3) der Batterie (1) angeordnet ist. Die Sensoranordnung (4) mit einer Polklemme (5) ist auf dem Minuspol (3) der Batterie (1) montiert, wobei diese Polklemme (5) einen Schraubanschluss (6) aufweist, über den ein Massekabel (7) mittels einer einschraubbaren Schraube mit dem Masseanschluss des Kraftfahrzeugs verbindbar ist.

## Beschreibung

### Stand der Technik

Die Erfindung betrifft eine Sensoranordnung für die Zustandserkennung einer Batterie, insbesondere als Bestandteil eines Energiemanagementsystem in Kraftfahrzeugen, nach der Gattung des Hauptanspruchs.

Um den Batteriezustand in einem Kraftfahrzeug zu ermitteln, kommen in der Regel an sich bekannte Batteriesensoren oder auch entsprechende elektronische Schaltungen in Batteriemanagementsystemen zum Einsatz. Mit dem Einsatz eines solchen Batteriesensors kann man basierend auf gemessenen Strom-, Spannungs- oder Temperaturwerten den Zustand der Batterie ermitteln und überwachen. Hiermit können verschiedene Batteriemanagementsysteme angewendet werden können, um sogenannte Tiefentladungen der Batterie zu vermeiden und auch die Startfähigkeit des Fahrzeuges weiterhin sicherzustellen.

Es ist beispielsweise aus der DE 10 2005 039 587 A1 bekannt, dass eine Erfassung des Zustands einer Batterie im Bordnetz eines Kraftfahrzeuges mit einer Batteriesensoreinheit durchgeführt wird. Diese Batteriesensoreinheit als Messstrecke mit einem Shuntwiderstand wird direkt an eine Polklemme der Batterie angeklemmt und kombiniert praktisch die Messstrecke mit der mechanischen Anschlusseinheit.

Weiterhin ist in der DE 10 2006 013 911 A1 beschrieben, dass ein Kommunikationsweg zwischen der Erfassung der Messwerte zur Prüfung elektrischer Verbraucher im Kraftfahrzeug und der Bewertung dieser daraus gewonnenen Daten über einen CAN- oder LIN-Bussystem einer Rechnereinheit zur Verfügung gestellt wird.

Es ist jedoch weiterhin auch üblich, dass Fahrzeuge nicht mit einem solchen Batteriesensor ausgestattet werden, sodass viele Defekte nur nach einem Werkstattbesuch und mit Unterstützung von geeigneten Tools entdeckt werden können, was einen erheblichen Kontaktierungsaufwand erforderlich macht.

### Offenbarung der Erfindung

Die Erfindung geht von einer Sensoranordnung für die Zustandserkennung einer Batterie in einem Kraftfahrzeug aus, die zur Erfassung der elektrischen Zustandsgrößen der Batterie in der Nähe oder an einer Polklemmen der Batterie angeordnet ist. Um die Sensoranordnung im Zusammenhang mit einem Diagnose Tool auch in Werkstätten einsetzen zu können, um verschiedene Defekte der Batterie zu erkennen, sollte eine geeignete mechanische Anpassung an diese Fahrzeuge, die nicht mit der Sensoranordnung ausgestattet wurden, ermöglicht werden. Erfindungsgemäß ist die Sensoranordnung mit einer Polklemme in vorteilhafter Weise auf dem Minuspol der Batterie derart montiert, dass diese Polklemme eine Schraubverbindung aufweist, über die ein Massekabel mittels einer in das entsprechende Innengewinde einschraubbaren Schraube mit dem Masseanschluss des Kraftfahrzeugs verbindbar ist.

Vorzugsweise ist die Sensoranordnung über einen Diagnosestecker mit einer zentralen Auswerteeinheit im Kraftfahrzeug verbindbar, sodass anschließend und nach der Durchführung von einigen Tests mögliche Defekte in einem Generator, einem Starter sowie auch in der Batterie des Kraftfahrzeuges entdeckt bzw. diagnostiziert werden können. Die Verbindung mit der zentralen Auswerteeinheit kann in an sich bekannter Weise über einen sogenannten LIN-Bus erfolgen.

Durch diese erfindungsgemäße Erweiterung kann die Sensoranordnung auch auf einfache Weise in der Werkstatt bei der Wartung eines Kraftfahrzeuges eingesetzt werden um die zuvor beschriebenen Defekte vom Generator, Starter oder von der Batterie zu entdecken. Die Sensoranordnung kann dadurch die Standard Tools, die ansonsten für die Wartung in der Werkstatt benutzt werden, ersetzen.

Andererseits ist auch möglich die Sensoranordnung während der Fahrzeugfertigung einzusetzen, um den Zustand der Batterie im Fertigungsablauf zu diagnostizieren, sodass auch hier Batteriedefekte in der Fertigung entdeckt werden können und zum Beispiel, bei gut geladenen Batterien überflüssige Nachladungen dadurch erspart werden können.

### Kurze Beschreibung der Zeichnung

Die Erfindung wird nachfolgend anhand des in der Figur der Zeichnung gezeigten Ausführungsbeispiels erläutert. Dabei zeigt:

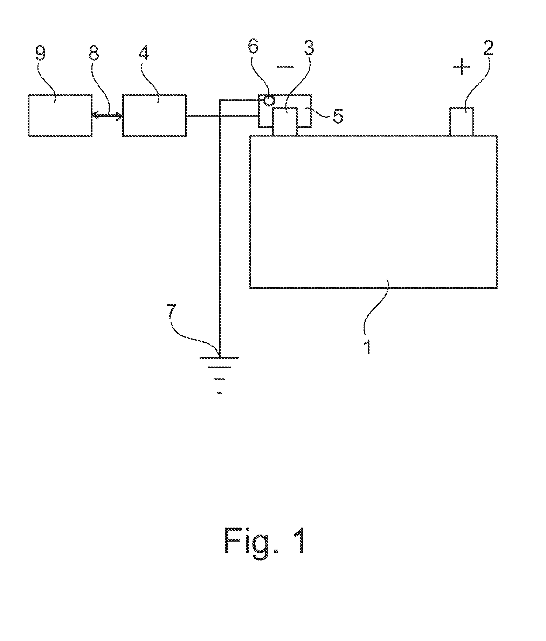

Figur 1 eine schematisches Blockschaltbild einer Anordnung einer Sensoranordnung im Bereich der Batterie eines Kraftfahrzeuges mit einem erfindungsgemäßen Masseanschluss.

### Ausführungsform der Erfindung

In Figur 1 ist eine Batterie 1 für ein Kraftfahrzeug gezeigt, deren Zustand durch Messung elektrischer Größen, insbesondere Strom, Spannung oder Temperatur, möglichst nahe an den Polklemmen 2 (+) und 3 (-) der Batterie 1 mit einer Sensoranordnung 4 als Batteriesensor erfasst werden soll.

Hier ist eine erfindungsgemäße Polklemme 5 vorhanden, die mit der Sensoranordnung 4 fest verbunden ist und die einen Schraubanschluss 6 für eine Masseanbindung 7 am Masseanschluss des Kraftfahrzeuges aufweist.

Über einen hier schematisch gezeigten LIN-Bus 8 können die Signale der Sensoranordnung 4 zu einer hier nicht näher erläuterten Auswerteeinheit 9 geführt werden, die zusätzlich zur Auswertung der Signale auch eine Durchführung von einigen Tests generieren kann, um mögliche Defekte in einem Generator, einem Starter sowie auch in der Batterie des Kraftfahrzeuges zu entdecken.

## Patentansprüche

1. Sensoranordnung für die Zustandserkennung einer Batterie (1) in einem Kraftfahrzeug, die zur Erfassung der elektrischen Zustandsgrößen der Batterie (1) in der Nähe der Polklemmen (2,3) der Batterie (1) angeordnet ist, **dadurch gekennzeichnet, dass** die Sensoranordnung (4) mit einer Polklemme (5) auf dem Minuspol (3) der Batterie (1) montiert ist, wobei diese Polklemme (5) einen Schraubanschluss (6) aufweist, über den ein Massekabel (7) mittels einer einschraubbaren Schraube mit dem Masseanschluss des Kraftfahrzeugs verbindbar ist.

2. Sensoranordnung nach Anspruch 1, **dadurch gekennzeichnet, dass** die Sensoranordnung (4) über eine Diagnoseverbindung mit einer zentralen Auswerteeinheit (9) im Kraftfahrzeug verbindbar ist.

3. Sensoranordnung nach Anspruch 2, **dadurch gekennzeichnet, dass** die Diagnoseverbindung mit der zentralen Auswerteeinheit (9) über einen LIN-Bus (8) erfolgt.

4. Sensoranordnung nach Anspruch 2 oder 3, **dadurch gekennzeichnet, dass** mit der zentralen Auswerteeinheit (9) ein Diagnosemodus zum Testen des Zustandes der Batterie (1) generierbar ist.
